# EUROPEAN PATENT APPLICATION

(11) **EP 2 299 550 A2**
(43) Date of publication of application: **23.03.2011**
(21) Application number: 10175539.5
(22) Date of filing: 07.09.2010
(51) Int. Cl.: H01S 5/40, H01S 5/00, G02B 27/09, G02B 6/42

(54) **Optical communication module and method for manufacturing the same**

(30) Priority: 18.09.2009 JP 2009217802
(71) Applicant: Nec Corporation, Tokyo 108-8001 (JP)
(72) Inventor: Tanaka, Hiromasa, Tokyo Tokyo 108-8001 (JP)
(74) Representative: Vossius & Partner

(57) **Abstract**

An optical communication module includes an array semiconductor laser (1) which emits light beams of plural wavelengths, an array lens (2) which brings each of the light beams emitted from the array semiconductor laser to parallel light, and an array mirror (3) which includes mirrors corresponding to the number of wavelengths and is provided at positions on which the light beams emitted from the array lens are incidentable, the respective mirrors selectively reflecting the light beams emitted from the array semiconductor laser.

## Description

This application is based upon and claims the benefit of priority from Japanese patent application No. 2009-217802, filed on September 18th, 2009, the disclosure of which is incorporated herein in its entirety by reference.

### TECHNICAL FIELD

The present invention relates to an optical communication module used in a large-capacity optical transmission system or the like and capable of oscillating light beams of plural wavelengths, and a method for manufacturing the optical communication module.

### BACKGROUND ART

With the proliferation of broadband access, the diversification of access means, and the diversification of services, etc., traffic in a communication line is growing. In order to cope with an increase in the traffic, a wavelength division multiplexing (WDM) optical transmission technology for multiplexing a light signal in a wavelength region and transmitting it has been brought into practical use.

An element length of a semiconductor laser is a few 100 µm or less. Power consumption thereof is also as small as a few 10mW or less. Thus, if a semiconductor laser is used as a light source, and a direct modulation system for modulating drive current of the semiconductor laser or a system for modulating light by an external modulator such as an LN (Lithium niobate) modulator, or an EA (Electroabsorption) modulator or the like is used, it is then possible to realize a size reduction in an optical transmission device or an optical communication device and a reduction in its power consumption.

Normally, in a wavelength division multiplexing optical transmission system, light sources corresponding to the number of wavelengths are prepared and the wavelengths of the respective light sources are set to a wavelength arrangement determined in advance. Then, light beams of respective wavelengths are combined together using a quartz waveguide or the like, followed by being output to an optical fiber (refer to, for example a patent document 1 (Japanese Patent Application Publication (JP-2000019362-A)).

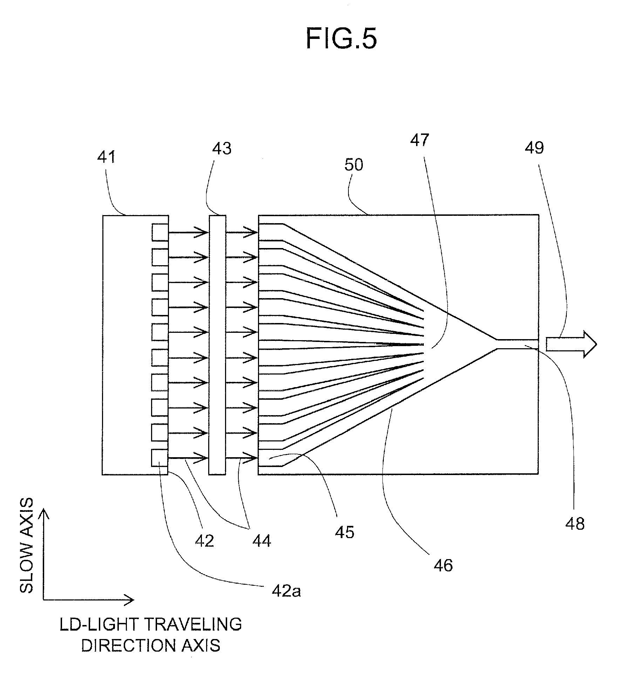

FIG. 5 is a plan view showing a configuration of an optical coupling device including a semiconductor laser described in the patent document 1. The optical coupling device shown in FIG. 5 has an array semiconductor laser 41, a cylindrical lens 43, and a light converger 50.

The array semiconductor laser 41 includes a plurality of optical radiation parts 42a arranged in linear form. A plurality of LD light (laser light) 44 are radiated at predetermined divergence angles from optical radiation faces 42 of the optical radiation parts 42a.

When an axis parallel to each of the optical radiation faces 42 is assumed to be a slow axis, an axis perpendicular to the optical radiation face 42 is assumed to be a traveling direction axis of each LD light, and an axis perpendicular to both of the LD-light traveling direction axis and the slow axis is assumed to be a first axis, each of the LD light 44 is greatly diverged in the direction of the first axis with the divergence angle in the slow-axis direction of the LD light 44 as a full-width-at-half-maximum of about 10 degrees and with the divergence angle thereof in the first-axis direction as a full-width-at-half-maximum of about 40 degrees. Thus, the light beams diverged in the first-axis direction are converted to parallel light by a cylindrical lens 43.

The optical converger 50 has optical waveguides 46 of the same number as the number of the optical radiation parts 42a in the array semiconductor laser 41. The optical waveguides 46 are narrowed in their arrangement interval in the traveling direction of the LD light 44 and thereby combined into one by a coupling part 47. The respective LD light 44 are launched from an outgoing port 48 as a high density LD light 49. Incidentally, such a laser array as illustrated in a patent document 2 (Japanese Patent Application Publication (JP-07226563-A)) can be used as the array semiconductor laser 41.

### SUMMARY

An exemplary object of the present invention is to provide an optical communication module rendered high in optical coupling efficiency at low cost, and a method for manufacturing the optical communication module.

According to an exemplary aspect of invention, for attaining the above object, there is provided an optical communication module comprising an array semiconductor laser which emits light beams of plural wavelengths, an array lens which brings each of the light beams emitted from the array semiconductor laser to parallel light, and an array mirror which includes mirrors corresponding to the number of wavelengths and is provided at positions on which the light beams emitted from the array lens are incidentable., the respective mirrors selectively reflecting the light beams emitted from the array semiconductor laser.

According to an exemplary aspect of invention, for attaining the above object, there is provided a method for manufacturing an optical communication module, comprising the steps of forming an array semiconductor laser which emits light beams of plural wavelengths, on a substrate; forming an array lens which brings each of the light beams emitted from the array semiconductor laser to parallel light on the substrate; and forming an array mirror which includes mirrors corresponding to the number of wavelengths and in which the respective mirrors selectively reflect the light beams emitted from the array semiconductor laser, at positions on which the light beams emitted from the array lens on the substrate are incidentable.

### BRIEF DESCRIPTION OF THE DRAWINGS

FIG. 1 is a perspective view showing a configuration example of an exemplary embodiment of an optical communication module according to the invention;

FIG. 2 is a plan view illustrating the optical communication module held in a package;

FIG. 3 is a flowchart showing a method for manufacturing the optical communication module;

FIG. 4 is an explanatory view depicting a schematic configuration of an optical communication module according to the invention; and

FIG. 5 is a plan view showing a configuration of an optical coupling device including a semiconductor laser described in the patent document 1.

### DESCRIPTION OF EMBODIMENT

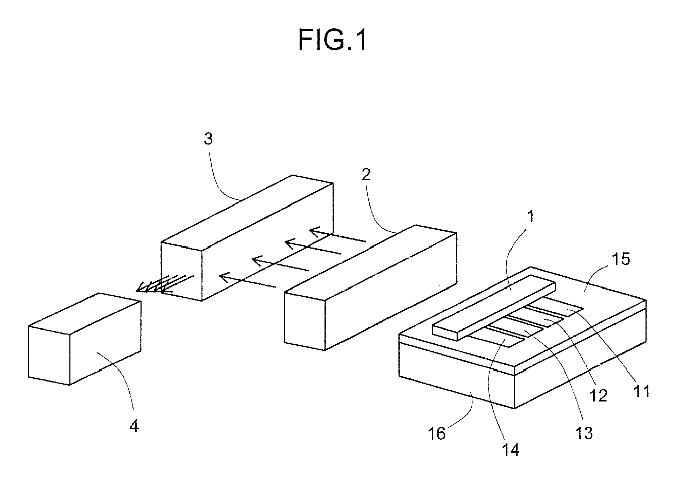

FIG. 1 is a perspective view showing a configuration example of an exemplary embodiment of an optical communication module according to the invention. The optical communication module shown in FIG. 1 includes an array semiconductor laser (which will be hereinafter referred to as array laser) 1, an aspheric array lens (which will be hereinafter referred to as array lens) 2 on which light beams emitted from the array laser 1 are incident, an array mirror 3 on which the light beams emitted from the array lens 2 are incident, and a lens 4 which causes the light beams from the array mirror 3 to converge and emits the same to an optical fiber (not shown).

Incidentally, electrodes 11, 12, 13, and 14 for supplying drive currents to the array laser 1, a substrate 15 for holding the array laser 1 and the electrodes 11, 12, 13, and 14, and a carrier 16 for supporting the substrate 15 are also shown in FIG. 1. The electrodes 11, 12, 13, and 14 are formed as, for example, microstrip lines. The substrate 15 is made of, for example, ceramic. The carrier 16 is made of, for example, CuW (copper tungsten).

The array laser 1 is of a semiconductor laser which emits a plurality of light beams different in wavelength. The array laser 1 emits the respective light beams modulated by an element (not shown) for carrying out direct modulation or an external modulator (not shown) such as an LN modulator or an EA modulator. The array lens 2 collimates the respective light beams emitted from the array laser 1 into parallel waves. The array mirror 3 changes the propagation direction of each light beam incident from the array lens 2 and launches the same into the lens 4.

The array laser 1 is assumed to be a four-wave array laser which emits a light beam consisting of four waves. The light beams different in wavelength, which are emitted from the array laser 1, are assumed to be a first light beam, a second light beam, a third light beam, and a fourth light beam respectively. The wavelength of the first light beam is assumed to be a first wavelength, the wavelength of the second light beam is assumed to be a second wavelength, the wavelength of the third light beam is assumed to be a third wavelength, and the wavelength of the fourth light beam is assumed to be a fourth wavelength.

The operation of the optical communication module illustrated in FIG. 1 will next be explained.
The array laser 1 has a structure in which four laser resonators are assembled, and includes four light emitting active layers which produce optical gain by their energization. When a voltage is applied between the electrodes 11, 12, 13, and 14 and their corresponding electrodes (not shown) provided on the back surface of the substrate 15, the light emitting active layers emit light beams different from one another in wavelength.

The four light beams emitted from the array laser 1 are launched into the array lens 2. The array lens 2 has a structure in which lenses for bringing the four light beams to parallel light are assembled. Thus, after the four light beams emitted from the array laser 1 have been brought to the parallel light by the array lens 2, they are launched into the array mirror 3.

Incidentally, the pitches of the four lenses that construct the array lens 2 (the intervals at which they are arranged) are respectively set to match with the intervals at which the four light emitting active layers of the array laser 1 are arranged. The intervals at which the four light emitting active layers are arranged, are the same. The respective lenses in the array lens 2 and their adjacent lenses are identical in spacing. Namely, the pitches of the four lenses are the same. Incidentally, the respective lenses and their adjacent lenses being identical in spacing means that the interval between a light incident position at each lens and a light incident position at its adjacent lens is the same with respect to any lens.

The array mirror 3 has a structure in which mirrors having filter functions for selectively reflecting the four light beams emitted from the array lens 2 are assembled. Namely, at the array mirror 3, the mirror on which an n (where n: any of 1 to 4)th light beam falls reflects an nth wavelength component and changes the traveling direction of the light beam by 90 degrees. Further, the mirror causes other wavelength components to penetrate. In other words, the array mirror 3 is of one in which mirrors having filter functions for selecting four wavelengths are assembled.

The four light beams emitted from the array mirror 3 are condensed by the lens 4 and thereafter emitted to the optical fiber.

Incidentally, the pitches of the four mirrors that construct the array mirror 3 (the intervals at which they are arranged) are set so as to match with the intervals at which the four light emitting active layers of the array laser 1 are arranged. The respective mirrors and their adjacent mirrors in the array mirror 3 are identical in spacing. Namely, the pitches of the four mirrors are the same. Incidentally, the respective mirrors and their adjacent mirrors being identical in spacing means that the interval between a light incident position at each mirror and a light incident position at its adjacent mirror is the same with respect to any mirror.

Assuming that the light beams emitted from the array laser 1 are respectively of light beams modulated at a bit rate of 25Gb/s or so, the capacity of transmission by the optical fiber can be brought to 100Gb/s or so. Thus, the optical communication module according to the present embodiment can be applied to a field related to a 100Gb/s transmission apparatus such as 100Gb/s Ethernet (Trademark), a CFP optical module or the like.

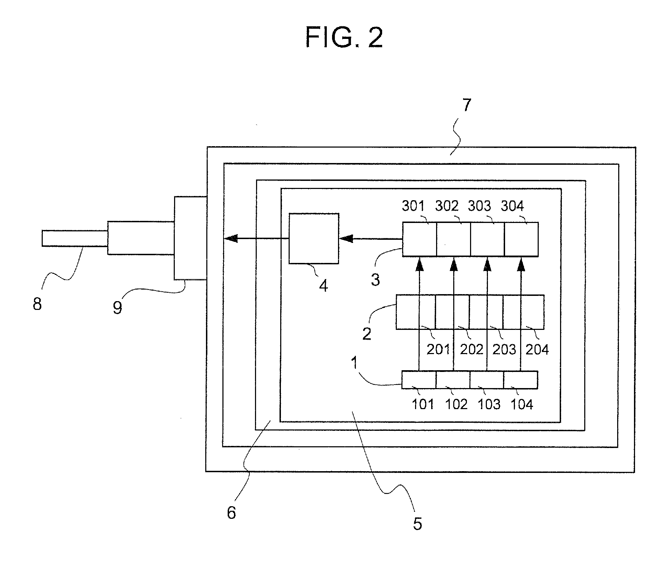

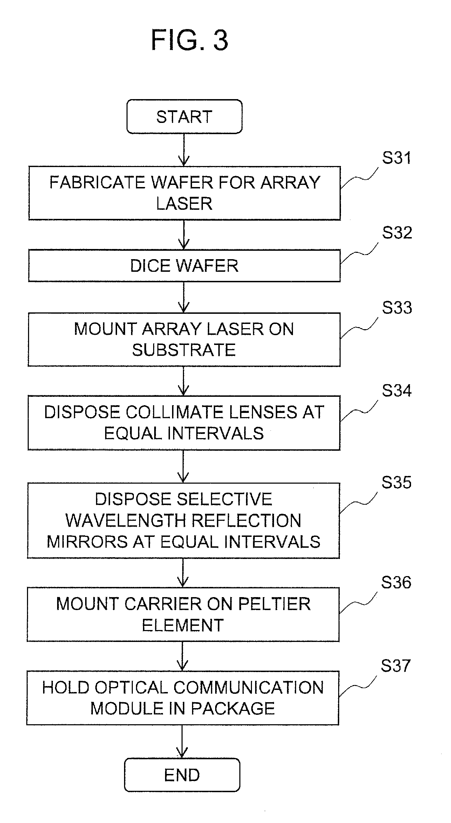

An optical communication module manufacturing method according to the invention will next be explained. FIG. 2 is a plan view showing an optical communication module held in a package. FIG. 3 is a flowchart showing the manufacturing method of the optical communication module. The module stored in the package corresponds to the optical communication module shown in FIG. 1. Namely, in the manufacturing method to be described below, the subassembled optical communication module shown in FIG. 1 is held within the package to thereby fabricate the packaged optical communication module.

A substrate 5 is provided on a carrier (not shown) made of CuW or Kovar or the like.

A wafer for the array laser 1 is fabricated (Step S31). Namely, a lower clad layer, a multi-quantum well active layer, an upper clad layer, and the like are laminated on, for example, a GaAs (gallium arsenide) substrate to form light emitting active layers. Gratings are formed by electron beam exposure in such a manner that four regions in the active layers formed in the wafer emit light beams of wavelengths different from each other. The regions in the wafer, which respectively emit the light beams of wavelengths, are separated from one another (Step S32). Namely, the wafer is diced to obtain four laser elements 101, 102, 103, and 104.

The diced four laser elements 101, 102, 103, and 104 are mounted onto the substrate 5 in such a manner that they are disposed or arranged on the substrate 5 at equal intervals (Step S33). Incidentally, the assembly of the laser elements 101, 102, 103, and 104 corresponds to the array laser 1 shown in FIG. 1. The equal intervals mean that the intervals of outgoing parts of four light beams are the same.

Next, aspheric lenses (e.g., convex lenses: which will be hereinafter referred to as collimate lenses) 201, 202, 203, and 204 for collimating the light beams emitted from the laser elements 101, 102, 103, and 104 are fabricated and placed in positions on which the light beams emitted from the laser elements 101, 102, 103, and 104 are incidentable, at equal intervals on the substrate 5 (Step S34). The equal intervals mean that the intervals of incoming parts of the four light beams are the same. The intervals are the same as those at which the laser elements 101, 102, 103, and 104 are arranged. Incidentally, the assembly of the collimate lenses 201, 202, 203, and 204 corresponds to the array lens 2. The collimate lenses 201, 202, 203, and 204 may be fabricated in advance without forming them immediately before execution of the process of Step S34.

Since the collimate lenses 201, 202, 203, and 204 are disposed at equal intervals, and the intervals at which the collimate lenses 201, 202, 203, and 204 are disposed, are the same as the intervals at which the laser elements 101, 102, 103, and 104 are disposed, for example, the optical axis of the collimate lens 201 may simply be matched with the optical axis (center of light emission) of the laser element 101, and adjustment work for matching the optical axes of other collimate lenses 202, 203, and 204 with the optical axes of the laser elements 102, 103, and 104 respectively becomes unnecessary. This is because after the optical axis of the collimate lens 201 and the optical axis (center of light emission) of the laser element 101 have been matched with each other, the collimate lenses 202, 203, and 204 may be arranged at equal intervals in sequence.

Four first through fourth multilayer film mirrors are fabricated which perform the function of reflecting a light beam of an n (where n: any of 1 to 4)th wavelength collimated by the array lens 2 as a light beam of a specific wavelength and causing a light beam of wavelength other than the specific wavelength to penetrate therethrough. The nth multilayer film mirror selectively reflects the light beam of the nth wavelength. Thus, the four multilayer film mirrors are hereinafter referred to as selective wavelength reflection mirrors 301, 302, 303, and 304.

The selective wavelength reflection mirrors 301, 302, 303, and 304 are disposed on the substrate 5 at equal intervals (Step S35). The equal intervals mean that the intervals of incoming and reflecting parts of the four light beams are the same. The intervals thereof are the same as the intervals at which the laser elements 101, 102, 103, and 104 are disposed. Incidentally, the assembly of the selective wavelength reflection mirrors 301, 302, 303, and 304 corresponds to the array mirror 3. The selective wavelength reflection mirrors 301, 302, 303, and 304 may be fabricated in advance without forming them immediately before execution of the process of Step S35.

Since the selective wavelength reflection mirrors 301, 302, 303, and 304 are disposed at equal intervals, and the intervals at which the selective wavelength reflection mirrors 301, 302, 303, and 304 are disposed, are the same as the intervals at which the laser elements 101, 102, 103, and 104 are disposed, for example, the optical axis of the selective wavelength reflection mirror 301 may simply be matched with the position of incident light, and hence adjustment work for matching the optical axes of other selective wavelength reflection mirrors 302, 303, and 304 with the position of the incident light becomes unnecessary. This is because after the optical axis of the selective wavelength reflection mirror 301 has been matched with the position of the incident light, the selective wavelength reflection mirrors 302, 303, and 304 may be disposed at equal intervals in sequence.

The directions of reflection by the selective wavelength reflection mirrors 301, 302, 303, and 304 are set such that the four reflected light are brought into a bundle. A lens 4 is provided on the optical path of the bundle of the reflected light. The lens 4 gathers the bundle of the reflected light.

Then, a carrier is mounted on a Peltier element 6 subjected to pre-soldering (Step S36). The Peltier element 6 is of an element used for temperature control. Further, the optical communication module is mounted inside, for example, a Kovar-made package 7 to achieve its hermetic sealing (Step S37). The package 7 is provided with a transmission hole 9 for causing a light beam from the lens 4 to pass therethrough. The light beam from the lens 4 passes through the transmission hole 9 and is thereafter coupled to an aligned optical fiber 8.

In the above exemplary embodiment as described above, since the components for obtaining light beams of plural wavelengths are respectively brought into assembly, the optical communication module can be reduced in size. Incidentally, the components for obtaining the light beams of the plural wavelengths correspond to the array laser 1, array lens 2, and array mirror 3.

Since the intervals at which the plural laser elements 101, 102, 103, and 104 being of the components of the array laser 1 are disposed, and the intervals at which the plural collimate lenses 201, 202, 203, and 204 being of the components of the array lens 2 are disposed, are the same respectively, the array laser 1 and the array lens 2 can be aligned with each other by simply performing the adjustment for matching the optical axis of one collimate lens with the optical axis of one laser element and providing other plural collimate lenses at equal intervals. Since the intervals at which the laser elements 101, 102, 103, and 104 are disposed, and the intervals at which the plural selective wavelength reflection mirrors 301, 302, 303, and 304 being of the components of the array mirror 3 are disposed, are the same respectively, the array laser 1 and the array mirror 3 can be aligned with each other by simply carrying out the adjustment for matching the optical axis of one selective wavelength reflection mirror with the position of the incident light from one collimate lens and locating other plural selective wavelength reflection mirrors at equal intervals.

Namely, in the above exemplary embodiment, the number of man-hours required for the adjustment upon fabrication of the optical communication module is reduced.

In the above exemplary embodiment as well, since there is not used an optical waveguide for combining light beams of plural wavelengths, the present optical communication module can be improved in optical coupling efficiency as compared with the optical communication module illustrated in FIG. 5, and the cost of the optical communication module is reduced.

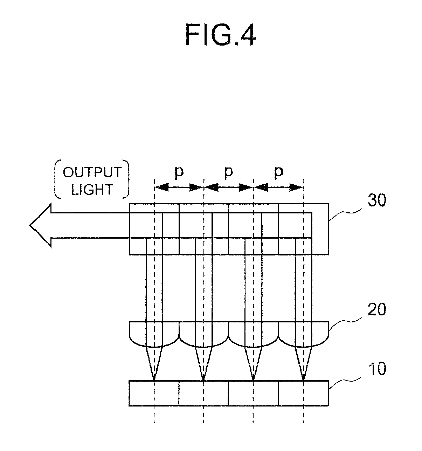

FIG. 4 is an explanatory view showing a schematic configuration of an optical communication module according to the invention. As shown in FIG. 4, the optical communication module is equipped with an array semiconductor laser 10 which emits light beams of plural wavelengths, an array lens 20 which brings each of the light beams of the plural wavelengths emitted from the array semiconductor laser 10 to parallel light, and an array mirror 30 which includes mirrors corresponding to the number of wavelengths and is provided at positions on which the light beams emitted from the array lens 20 are incidentable, the respective mirrors selectively reflecting the light beams of the plural wavelengths emitted from the array semiconductor laser 10.

The array semiconductor laser 10 includes a plurality of laser elements which respectively emit light beams having wavelengths different from one another. The array lens 20 includes a plurality of collimate lenses provided corresponding to the laser elements respectively. The intervals (p shown in FIG. 4) at which the collimate lenses are arranged, are preferably identical to the intervals (p shown in FIG. 4) at which the laser elements are arranged.

Preferably, the mirrors of the array mirror 30 are respectively provided corresponding to the laser elements, and the intervals (p shown in FIG. 4) at which the mirrors are disposed, are respectively the same as the intervals (p shown in FIG. 4) at which the laser elements are disposed.

As shown in FIG. 4, the mirrors of the array mirror 30 are preferably placed in such a manner that the light beams reflected by the mirrors of the array mirror 30 are brought to one light bundle.

The structure of the optical communication module may be of a structure in which the array semiconductor laser 10, the array lens 20, the array mirror 30, and a lens for gathering a plurality of light beams emitted from the array mirror are held in a package made of a metal (refer to FIG. 2).

Incidentally, in general, a waveguide consisting of quartz is comparatively high in cost, and an optical communication module using the quartz waveguide becomes expensive. Also, a problem arises in that since the optical coupling loss of the quartz waveguide is not small, the output level of multiplexed light is reduced.

An exemplary advantage according to the invention is, however, that an optical communication module rendered high in optical coupling efficiency can be obtained at low cost.

The invention can be applied suitably to an optical communication module used in a large-capacity optical transmission system or the like.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

The whole or part of the exemplary embodiments disclosed above can be described as, but not limited to, the following supplementary notes.

### (Supplementary note 1)

An optical communication module comprising an array semiconductor laser which emits light beams of plural wavelengths, an array lens which brings each of the light beams emitted from the array semiconductor laser to parallel light, and an array mirror which includes mirrors corresponding to the number of wavelengths and is provided at positions on which the light beams emitted from the array lens are incidentable, the respective mirrors selectively reflecting the light beams emitted from the array semiconductor laser.

### (Supplementary note 2)

In the optical communication module described in the supplementary note 1, the array semiconductor laser includes a plurality of laser elements which emit light beams of wavelengths different from one another respectively. The array lens includes a plurality of collimate lenses provided corresponding to the laser elements respectively. Intervals at which the collimate lenses are arranged, are respectively the same as intervals at which the laser elements are arranged.

### (Supplementary note 3)

In the optical communication module described in the supplementary note 1 or 2, the mirrors of the array mirror are provided corresponding to the laser elements respectively, and intervals at which the mirrors are arranged are respectively the same as the intervals at which the laser elements are arranged.

### (Supplementary note 4)

In the optical communication module described in any one of the supplementary notes 1 to 3, the mirrors of the array mirror are provided in such a manner that the light beams reflected by the mirrors of the array mirror are brought into one light bundle.

### (Supplementary note 5)

In the optical communication module described in any one of the supplementary notes 1 to 4, the array semiconductor laser, the array lens, the array mirror, and a lens for gathering the plural light beams emitted from the array mirror are held in a package made of a metal.

### (Supplementary note 6)

A method for manufacturing an optical communication module, comprising: forming an array semiconductor laser, which emits light beams of plural wavelengths, on a substrate, forming an array lens, which brings each of the light beams emitted from the array semiconductor laser to parallel light, on the substrate, and forming an array mirror which includes mirrors corresponding to the number of wavelengths and in which the respective mirrors selectively reflect the light beams emitted from the array semiconductor laser, at positions on which the light beams emitted from the array lens on the substrate are incidentable.

### (Supplementary note 7)

The method according to Supplementary note 6, further comprising: forming a plurality of laser elements respectively emitting light beams of wavelengths different from one another in a wafer and thereafter separating the laser elements from one another, mounting the laser elements on the substrate, forming a plurality of collimate lenses respectively provided corresponding to the laser elements as the array lens, mounting the collimate lenses on the substrate at positions on which the light beams emitted from the laser elements are incidentable, and setting intervals at which the collimate lenses are arranged, to be identical to intervals at which the laser elements are arranged.

### (Supplementary note 8)

The method according to Supplementary note 6 or 7, further comprising: setting intervals at which the mirrors of the array mirror are arranged, to be identical to the intervals at which the laser elements are arranged.

### (Supplementary note 9)

The method according to any one of Supplementary notes 6 to 8, further comprising: holding the array semiconductor laser, the array lens, the array mirror, and a lens for gathering the plural light beams emitted from the array mirror in a package made of a metal.

## Claims

1. An optical communication module comprising:
an array semiconductor laser which emits light beams of plural wavelengths;
an array lens which brings each of the light beams emitted from the array semiconductor laser to parallel light; and
an array mirror which includes mirrors corresponding to the number of wavelengths and is provided at positions on which the light beams emitted from the array lens are incidentable, the respective mirrors selectively reflecting the light beams emitted from the array semiconductor laser.

2. The optical communication module according to claim 1,
wherein the array semiconductor laser includes a plurality of laser elements which emit light beams of wavelengths different from one another respectively,
wherein the array lens includes a plurality of collimate lenses provided corresponding to the laser elements respectively, and
wherein intervals at which the collimate lenses are arranged, are respectively the same as intervals at which the laser elements are arranged.

3. The optical communication module according to claim 1 or 2,
wherein the mirrors of the array mirror are provided corresponding to the laser elements respectively, and
wherein intervals at which the mirrors are arranged are respectively the same as the intervals at which the laser elements are arranged.

4. The optical communication module according to any one of claims 1 to 3, wherein the mirrors of the array mirror are provided in such a manner that the light beams reflected by the mirrors of the array mirror are brought into one light bundle.

5. The optical communication module according to any one of claims 1 to 4, wherein the array semiconductor laser, the array lens, the array mirror, and a lens for gathering the plural light beams emitted from the array mirror are held in a package made of a metal.

6. A method for manufacturing an optical communication module, comprising:
forming an array semiconductor laser which emits light beams of plural wavelengths, on a substrate;
forming an array lens which brings each of the light beams emitted from the array semiconductor laser to parallel light on the substrate; and
forming an array mirror which includes mirrors corresponding to the number of wavelengths and in which the respective mirrors selectively reflect the light beams emitted from the array semiconductor laser, at positions on which the light beams emitted from the array lens on the substrate are incidentable.

7. The method according to claim 6, further comprising:
forming a plurality of laser elements respectively emitting light beams of wavelengths different from one another in a wafer and thereafter separating the laser elements from one another;
mounting the laser elements on the substrate;
forming a plurality of collimate lenses respectively provided corresponding to the laser elements as the array lens;
mounting the collimate lenses on the substrate at positions on which the light beams emitted from the laser elements are incidentable; and
setting intervals at which the collimate lenses are arranged, to be identical to intervals at which the laser elements are arranged.

8. The method according to claim 6 or 7, further comprising:
setting intervals at which the mirrors of the array mirror are arranged, to be identical to the intervals at which the laser elements are arranged.

9. The method according to any one of claims 6 to 8, further comprising:
holding the array semiconductor laser, the array lens, the array mirror, and a lens for gathering the plural light beams emitted from the array mirror in a package made of a metal.
